# EUROPEAN PATENT SPECIFICATION

(11) **EP 3 249 706 B1**
(45) Date of publication and mention of the grant of the patent: **18.03.2020**
(21) Application number: 16171382.1
(22) Date of filing: 25.05.2016
(51) Int. Cl.: H01L 45/00

(54) **A RARE-EARTH METAL OXIDE RESISTIVE RANDOM ACCESS NON-VOLATILE MEMORY DEVICE**
NICHTFLÜCHTIGE DIREKTZUGRIFFSPEICHERVORRICHTUNG AUS SELTENERD-METALLOXID
DISPOSITIF DE MÉMOIRE RÉSISTIF NON VOLATILE À ACCÈS ALÉATOIRE À OXYDE MÉTALLIQUE DE TERRES RARES

(43) Date of publication of application: 29.11.2017
(73) Proprietor: IMEC VZW, 3001 Leuven (BE); Katholieke Universiteit Leuven, 3000 Leuven (BE)
(72) Inventor: Goux, Ludovic, 3001 Leuven (BE); Fantini, Andrea, 3001 Leuven (BE); Chen, Chao-Yang, 3001 Leuven (BE)
(74) Representative: Patent Department IMEC

(56) References cited:
- US-A1- 2014 299 832
- US-A1- 2015 364 679
- CHAO YANG CHEN ET AL: "Low-current operation of novel Gd 2 O 3 -based RRAM cells with large memory window", PHYSICA STATUS SOLIDI. A: APPLICATIONS AND MATERIALS SCIENCE, vol. 213, no. 2, 8 February 2016 (2016-02-08), pages 320-324, XP55324102, DE ISSN: 1862-6300, DOI: 10.1002/pssa.201532377
- LIU K C ET AL: "The resistive switching characteristics of a Ti/Gd2O3/Pt RRAM device", MICROELECTRONICS AND RELIABILITY, ELSEVIER SCIENCE LTD, GB, vol. 50, no. 5, 1 May 2010 (2010-05-01), pages 670-673, XP027036196, ISSN: 0026-2714 [retrieved on 2010-04-29]

## Description

### Field

The present disclosure is related to Resistive Random Access non-volatile Memory devices, also known as RRAM or ReRAM. In particular the disclosure relates to RRAM devices comprising a rare-earth metal oxide layer.

### Background

A non-volatile RRAM device comprises a dielectric solid-state layer sandwiched between a top and a bottom electrode. Information is stored in the RRAM device by reversibly switching the electrical resistance of the device between a low resistive state (LRS), also known as on-resistance (Ron) and a high resistive state (HRS), also known as off-resistance (Roff). This switching of the electrical resistance is done using an electrical current or voltage, respectively creating or disrupting conductive filament paths in the dielectric layer. A characteristic of such RRAM is the ratio between its high resistive state (LRS) and its low resistive state (HRS), which ratio is known as the memory window.

Oxygen-vacancy based RRAM technology uses an oxide layer as the solid-state dielectric layer. When switching the device to the low resistive state, i.e. setting the device, a chain of oxygen-vacancy (Vo) defects is created along such conductive filament (CF). Switching the device to the high resistive state, i.e. resetting the device, corresponds to the annihilation of these defects by the recombination of oxygen and oxygen-vacancies, i.e. O-Vo recombination. The resistance value of the low resistive state is controlled by the set programming current, while the resistance value of the high resistive state state is controlled by the reset programming voltage.

For an optimum bipolar-switching operation of the oxygen-vacancy based RRAM device, asymmetric devices are typically used. One electrode shows a higher oxygen affinity, while the opposite electrode shows a lower oxygen affinity. This difference in oxygen affinity between the two electrodes results in an oxygen-vacancy profile from the lower oxygen affinity electrode towards the higher oxygen affinity electrode, also known as oxygen scavenging electrode. Most of such RRAM devices use TiN, TaN, or Ru as the low-affinity electrode and Ti, Hf, or Ta as the oxygen-scavenging electrode. These choices of electrode metal make such devices more CMOS compatible. The oxide layer in-between the two electrodes is most often a transition-metal oxide layer, such as TiO2, Ta2O5 or HfO2. Preferably the metal of this oxide layer is also used to form the oxygen-scavenging electrode, e.g. a Ta-electrode is formed on a Ta2O5 oxide layer.

In such oxygen-vacancy based RRAM technology, the recovery of the oxygen-vacancy (Vo) defects during reset, i.e. the recombination of the oxygen and the oxygen-vacancy, improves with increasing reset voltage. However this recovery remains limited resulting in a saturation of the high resistive state at a given level. Due to this saturation, typical state-of-the-art RRAM devices may show a typical limited memory window of about 10 for an operating set current of 50uA.

The set-reset programming cycle involves the motion of O- species at each programming cycle. This mechanism degrades with the number of programming cycles performed. Typical state-of-the-art RRAM devices operated at a set current 50uA may show endurance failure even after 10⁸ set-reset cycles.

In the article "Low-current operation of novel Gd2O3-based RRAM cells with large memory window" from Chen et al. (Phys. Status Solidi A 213 (2), p.320-324 - 2016) the potential of using a hygroscopic material is evaluated, more specifically a TiN\Gd2O3\Hf\TiN OxRRAM device is disclosed. The specific stack has a much larger memory window than a previously published stack based on HfAlO

In another article "The resistive switching characteristics of a Ti/Gd2O3/Pt RRAM device" from Liu et al. (Microelectronics Reliability 50, p.670-673 (2010)) the resistance switching behaviour of Ti/Gd2O3/Pt and its dependency on the electrode material under a unipolar operation is evaluated. Reference is also made to prior art documents US2015364679 and US2014299832.

US2015364679 teaches a conductive bridging type memory device (CBRAM) comprising an electrolyte layer of Gd₂O₃ doped with 5-20% Al to create oxygen vacancies therein, facilitating the movement of mobile ions and thus the formation of the conductive filament.

### Aim

The present disclosure aims to disclose an oxygen-vacancy based RRAM device which doesn't suffer from the deficiencies of the prior art. It aims to disclose a RRAM device with increased memory window. In particular it is an aim to disclose an oxygen-vacancy based RRAM device with increased endurance lifetime.

### Brief description of the figures

For the purpose of teaching, drawings are added. These drawings illustrate some aspects and embodiments of the disclosure. They are only schematic and non-limiting. The size of some of the elements may be exaggerated and not drawn on scale for illustrative purposes. The dimensions and the relative dimensions do not correspond to actual reductions to practice of the disclosure. Like features are given the same reference number.
FIG 1 illustrates a schematic cross-section of a known RRAM device.
FIG 2 illustrates a schematic cross-section of a RRAM device according to the present invention.
FIG 3 illustrates a schematic cross-section of another known RRAM device.
FIG 4 shows the benchmarking of memory window vs endurance lifetime of the RRAM device of FIG 3 with prior art RRAM devices.
FIG 5 shows the benchmarking of the memory window vs pulse width of the RRAM device of FIG 3 with prior art RRAM devices.

### Description

The present disclosure will be described with respect to particular embodiments and with reference to certain drawings but the disclosure is not limited thereto. Furthermore, the terms first, second and the like in the description, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein. Moreover, the terms top, under and the like in the description are used for descriptive purposes and not necessarily for describing relative positions. It is to be understood that the terms so used are interchangeable under appropriate circumstances and that the embodiments of the disclosure described herein are capable of operation in other orientations than described or illustrated herein.

In this disclosure a RRAM device is presented providing improved reliability at low-current operation. The programming current Iₚ can be less than 50pA, typically less than 10pA, at a pulse width PW of less than 100us, typically less than 10us. This improvement in reliability is seen inter alia by the larger memory window even when multiple set-reset cycles are performed. The RRAM device allows a deep reset as the self-limiting character of the reset mechanism is mitigated. The degradation of the switching control at these low programming currents due to the low number of oxygen-vacancy defects involved in the switching mechanisms

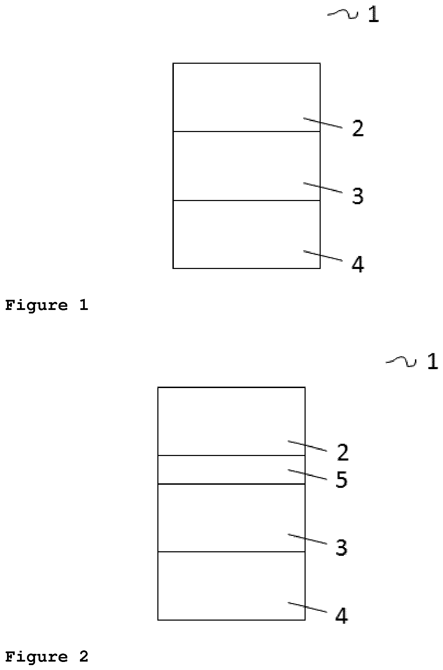

FIG 1 shows a schematic cross-section of an oxygen-vacancy based RRAM device **1** suitable for understanding the present invention. The device comprises an solid-state metal oxide layer **3** in-between a top, higher oxygen-affinity, electrode **2** and a bottom, lower oxygen-affinity, electrode **4**. This difference in oxygen affinity between the two electrodes results in an oxygen-vacancy profile from the lower oxygen affinity electrode towards the higher oxygen affinity electrode. Hence an assymetric device is obtained improving bipolar switching thereof.

The metal oxide layer **3** is hygroscopic and comprises hydroxyl groups (OH-). The advantage of using (OH-) groups as active species is that they are much faster and more reactive than e.g. O2-. These hydroxyl groups improve hence the efficiency of the reset switching whereby oxygen vacancies (Vo) recombine with oxygen species thereby annihilating the defects in the conductive filament formed in the dielectric layer **3.** They increase the saturation level of the high resistance state reached after reset compared to state-of-the-art RRAM devices. Thus, by controllably embedding (OH-) species in the oxide layer **3**, the memory window of the RRAM device **1** can be improved. Also the endurance performance of the RRAM device **1** may be improved by this change in active species in the switching mechanism from O-based species to OH- based species.

These hydroxyl groups are controllably embedded in the metal oxide layer during formation thereof. Thanks to the hygroscopic nature of the metal oxide layer, the hydroxyl groups readily adsorb during the metal oxide layer formation and remain embedded in this metal oxide layer even after the completion of the RRAM device. Depending on the concentration of the hygroscopic material in the metal oxide layer **3** a more thermodynamically stable material configuration is obtained resulting in an improved control of the hydroxyl concentration.

Preferably, the metal oxide layer **3** is a rare-earth metal oxide layer having hygroscopic properties. More preferably, the metal oxide layer **3** is a Gadolinium-Oxide layer.

This rare-earth metal oxide layer **3** can be doped with Aluminium (Al) or Silicon (Si). Preferably this doping is in the range from above 0 to about 50 atomic percent. More preferably this doping is in the range from above 0 to about 30 atomic percent. Doping the rare-earth metal layer may increase the electrical resistance of the metal oxide layer **3**. For example an Aluminium doped Gadolinium-oxide layer, such as Al-doped Gd₂O₃, can be used as metal-oxide layer **3**, whereby the Aluminium concentration ranges from above 0 to about 30 atomic percent.

Typically, metals such as TiN or TaN are used as metal for the lower oxygen affinity electrode **4** of the device illustrated by FIG 1. Preferably, the lower oxygen affinity electrode **4** should be formed from a metal having an even lower oxygen affinity. The lower the oxygen affinity of the bottom electrode **3**, the more the endurance lifetime is increased. Examples of such metals are Iridium, Iridium Oxide, Ruthenium, Ruthenium Oxide and Platinum. These metals have the further advantage that they are hydrogen catalysts. As such, they further improve the reset efficiency and hence the memory window of the RRAM device **1**.

Typically, metals such as Ti, Hf or Ta are used as metal for the higher oxygen affinity electrode **2**. In this respect, Ti is preferred over Hf or Ta. However, in order to further improve the lifetime of the RRAM device **1**, a more hygroscopic scavenging material can be used. Such a material may retain the hydroxyl groups closer to the higher oxygen affinity electrode **2**, thereby retarding the shift in the low resistance state when cycling the device **1**. A reduced low resistance state retention loss may hence be obtained.

Preferably a rare earth metal is used to form the higher oxide affinity electrode as it is the rare earth metal that provides the hygroscopic property. More preferably, this rare earth metal is the metal of the metal oxide layer **3**. For example, a layer **5** of Gadolinium can be present in between a Gadolinium-oxide layer **3** and the higher oxygen affinity electrode **2**.

Whereas in FIG 1 the material of the higher oxide affinity electrode was modified to increase the oxygen scavenging properties thereof, alternatively an additional scavenging layer **5** may be inserted in between the electrode **2** and the metal oxide layer **3** as illustrated by FIG 2. This scavenging layer also retains the hydroxyl groups closer to electrode **2**. According to the present invention, the scavenging layer **5** is formed from the rare earth metal of the rare earth metal oxide layer **3**. For example, a layer **5** of Gadolinium can be present in between a Gadolinium-oxide layer **3** and the higher oxygen affinity electrode **2**.

In an exemplary embodiment a Gadolinium-oxide layer, such as Gd₂O₃, is used as metal oxide layer **3** which is doped with Aluminium and/or Silicon in the range from above 0 to about 30 atomic percent.

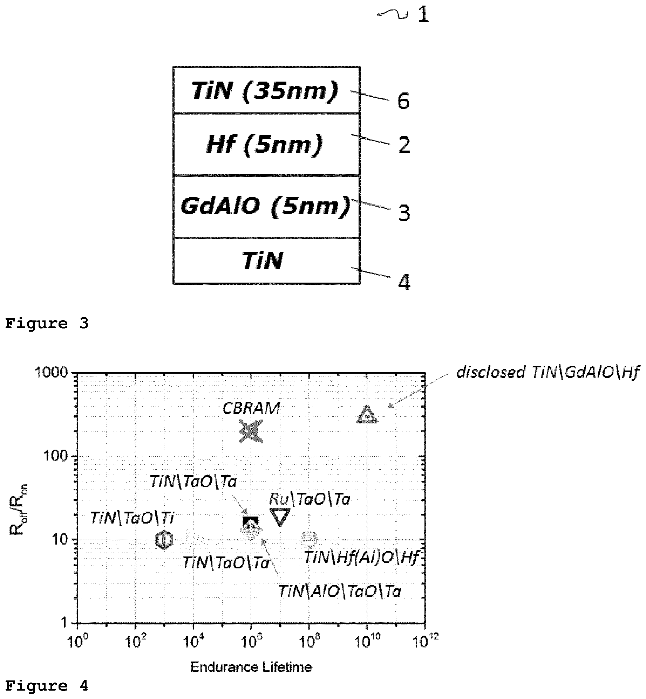

In an exemplary RRAM device, such as known from the afore-mentioned article by Chen et al, 5nm-thick hygroscopic oxide layer **3** were formed by atomic-layer deposition (ALD). The oxide layer **3** was integrated between a TiN **4** and a Hf **2** electrode, as shown in FIG 3, in 1-Transistor/1-Resistor configuration. On the Hf electrode **2** a TiN contact electrode **6** is formed. Using industry-relevant programming current (Ip)≤10µA and pulse-width (PW)≤10µs, the 40nm-sized TiN\Gd-Al-O\Hf cells allowed reaching a median memory window (MW) of more than 50. In a similar device configuration state of the art materials only exhibited a MW<x10 for the same operating conditions. Based on the large MW and good write endurance properties (>106 cycles) of Gd-Al-O based cells, verify algorithms allowed reliable programming with low latency. The disclosed device exhibited fast switching characteristics, i.e. between 0s and 10us, typically about 1us.

As shown in FIG 4, the memory window and the endurance lifetime of the device of FIG 3, measured using a programming current of 50uA for a pulse width of 100ns and optimized voltage conditions , is substantially larger than of prior art devices.

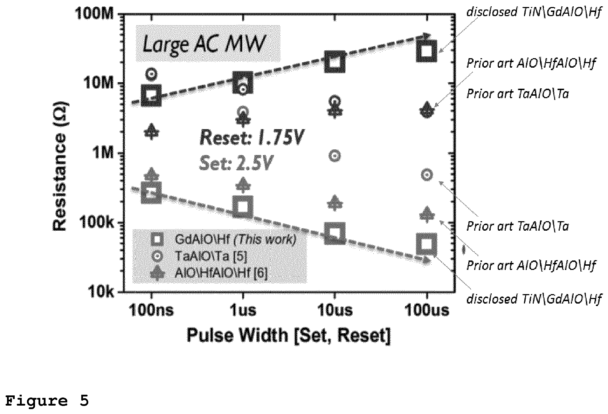

FIG 5 shows the change in resistance of the low resistive state (LRS, set) and the high resistive state (HRS, reset) with reduced pulse width. The device of FIG 3 maintained a lower on-resistance (LRS) and higher off-resistance (HRS) compared to prior art devices.

## Claims

1. An oxygen-vacancy based resistive random access memory device (1) comprising a stack of a lower oxygen affinity bottom electrode (4), a rare earth metal oxide layer (3), comprising hydroxyl groups, and a higher oxygen affinity top electrode (2), wherein the rare earth metal oxide layer is doped with aluminum and/or silicon with dopant ranges from above 0 to about 50 atomic percent, **characterized in that** the stack further comprises a scavenging layer (5) in between the rare earth metal oxide layer (3) and the higher oxygen affinity top electrode (2), the scavenging layer (5) comprising a rare earth metal being the same as the rare earth metal of the rare earth metal oxide layer (3).

2. The device according to claim 1, wherein this dopant range is from above 0 to about 30 atomic percent.

3. The device according to any of the foregoing claims, wherein the lower oxygen affinity electrode (4) is formed from a material from the group of platinum, iridium, iridium oxide, ruthenium and ruthenium oxide or a combination thereof.

4. The device according to any of the foregoing claims, wherein the higher oxygen affinity electrode (2) is formed from a material selected from the group of Ti, Hf or Ta.

## Patentansprüche

1. Auf Sauerstoffleerstellen basierte resistive Direktzugriffsspeichervorrichtung (1), umfassend einen Stapel aus einer unteren Elektrode (4) mit niedrigerer Sauerstoffaffinität, einer Seltenerdmetalloxidschicht (3) umfassend Hydroxylgruppen und einer oberen Elektrode (2) mit höherer Sauerstoffaffinität,
wobei
die Seltenerdmetalloxidschicht mit Aluminium und/oder Silizium mit Dotierstoffbereichen von über 0 bis etwa 50 Atomprozent dotiert ist, **dadurch gekennzeichnet, dass** der Stapel weiter eine Sauerstofffängerschicht (5) zwischen der Seltenerdmetalloxidschicht (3) und der oberen Elektrode (2) mit höherer Sauerstoffaffinität umfasst, wobei die Sauerstofffängerschicht (5) ein Seltenerdmetall umfasst, das das gleiche wie das Seltenerdmetall der Seltenerdmetalloxidschicht (3) ist.

2. Vorrichtung nach Anspruch 1, wobei dieser Dotierstoffbereich von über 0 bis etwa 30 Atomprozent beträgt.

3. Vorrichtung nach einem der vorstehenden Ansprüche, wobei die Elektrode (4) mit niedrigerer Sauerstoffaffinität aus einem Material aus der Gruppe von Platin, Iridium, Iridiumoxid, Ruthenium und Rutheniumoxid oder einer Kombination davon gebildet ist.

4. Vorrichtung nach einem der vorstehenden Ansprüche, wobei die Elektrode (2) mit höherer Sauerstoffaffinität aus einem Material gebildet ist, das aus der Gruppe von Ti, Hf oder Ta ausgewählt ist.

## Revendications

1. Dispositif de mémoire résistif à accès aléatoire à base de lacunes d'oxygènes (1) comprenant un empilement d'une électrode inférieure à plus faible affinité pour l'oxygène (4), d'une couche d'oxyde métallique de terre rare (3), comprenant des groupes hydroxyle, et d'une électrode supérieure à plus forte affinité pour l'oxygène (2),
dans lequel la couche d'oxyde métallique de terre rare est dopée avec de l'aluminium et/ou du silicium avec des plages de dopant allant de plus de 0 à environ 50 en pourcentage atomique,
**caractérisé en ce que** l'empilement comprend en outre une couche de piégeage (5) entre la couche d'oxyde métallique de terre rare (3) et l'électrode supérieure à plus forte affinité pour l'oxygène (2), la couche de piégeage (5) comprenant un métal de terre rare qui est le même que le métal de terre rare de la couche d'oxyde métallique de terre rare (3).

2. Dispositif selon la revendication 1, dans lequel cette plage de dopant va de plus de 0 à environ 30 en pourcentage atomique.

3. Dispositif selon l'une quelconque des revendications précédentes, dans lequel l'électrode à plus faible affinité pour l'oxygène (4) est formée à partir d'un matériau issu du groupe composé du platine, de l'iridium, de l'oxyde d'iridium, du ruthénium et de l'oxyde de ruthénium ou d'un mélange de ceux-ci.

4. Dispositif selon l'une quelconque des revendications précédentes, dans lequel l'électrode à plus forte affinité pour l'oxygène (2) est formée à partir d'un matériau choisi dans le groupe composé de Ti, Hf ou Ta.
